(19) Europäisches Patentamt / European Patent Office / Office européen des brevets

(11) **EP 3 341 770 B1**

(12) **EUROPÄISCHE PATENTSCHRIFT**

(45) Veröffentlichungstag und Bekanntmachung des Hinweises auf die Patenterteilung:
**17.07.2024   Patentblatt 2024/29**

(21) Anmeldenummer: **16763456.7**

(22) Anmeldetag: **24.08.2016**

(51) Internationale Patentklassifikation (IPC):
**G02B 5/08** (2006.01)

(52) Gemeinsame Patentklassifikation (CPC):
**G02B 5/0858; C23C 14/024; C23C 14/16;
C23C 16/0272; C23C 16/06; C23C 28/322;
C23C 28/345; C23C 28/3455; G02B 1/10;
G02B 1/14; G02B 5/08; G02B 5/0808**

(86) Internationale Anmeldenummer:
**PCT/EP2016/069990**

(87) Internationale Veröffentlichungsnummer:
**WO 2017/032807 (02.03.2017 Gazette 2017/09)**

(54) **REFLEKTIERENDES VERBUNDMATERIAL MIT EINEM ALUMINIUM-TRÄGER UND MIT EINER SILBER-REFLEXIONSSCHICHT**

REFLECTIVE COMPOSITE MATERIAL COMPRISING AN ALUMINUM SUBSTRATE AND A SILVER REFLECTIVE LAYER

MATÉRIAU COMPOSITE RÉFLÉCHISSANT À SUPPORT EN ALUMINIUM ET À COUCHE RÉFLÉCHISSANTE EN ARGENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.08.2015   DE 102015114095**

(43) Veröffentlichungstag der Anmeldung:
**04.07.2018   Patentblatt 2018/27**

(60) Teilanmeldung:
**20152866.8 / 3 660 550**

(73) Patentinhaber: **ALANOD GmbH & Co. KG**
**58256 Ennepetal (DE)**

(72) Erfinder:
• **TEMPLIN, Frank**
  **58313 Herdecke (DE)**
• **ZIEGLER, Stefan**
  **45549 Sprockhövel (DE)**
• **TITZ, Tobias**
  **42781 Haan (DE)**
• **AUSTGEN, Michael**
  **42555 Velbert (DE)**
• **PEROS, Dimitrios**
  **57074 Siegen (DE)**

(74) Vertreter: **Dr. Solf & Zapf
Patent- und Rechtsanwalts PartG mbB
Schlossbleiche 20
42103 Wuppertal (DE)**

(56) Entgegenhaltungen:
EP-A1- 0 918 234          EP-A1- 1 154 289
EP-A1- 1 867 934          EP-A1- 1 918 740
EP-A2- 2 312 234          EP-B1- 1 881 893
DE-A1- 102010 013 865     DE-A1- 102012 108 719
DE-U1- 202011 051 927     DE-U1- 29 812 559
US-A1- 2010 261 036       US-A1- 2015 138 782

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die vorliegende Erfindung betrifft ein reflektierendes Verbundmaterial mit einem aus Aluminium bestehenden Träger, mit einer auf dem Träger befindlichen Zwischenschicht aus anodisch oxidiertem Trägermaterial und mit einem über der Zwischenschicht aufgebrachten optisch wirksamen Mehrschichtsystem, welches aus mindestens drei Schichten besteht, wobei die oberen Schichten dielektrische und/oder oxidische Schichten sind, und die unterste Schicht eine metallische, aus Silber bestehende Schicht ist, welche eine Reflexionsschicht bildet.

Ein derartiges Verbundmaterial hat als oberflächenveredeltes Aluminiumband unter dem Namen MIRO®-Silver weite Verbreitung für die Beleuchtungstechnik, Tageslichtsysteme und dekorative Anwendungen gefunden. Die Oberflächenbehandlung dient dabei dazu, die empfindliche Aluminumoberfläche besser zu schützen und den Lichtreflexionsgrad zu erhöhen. Der Oberflächenveredelungsvorgang besteht aus zwei unterschiedlichen Prozessen, die beide kontinuierlich betrieben werden können, und zwar aus der Erzeugung der Zwischenschicht in einem nasschemischen Prozess, der zusammenfassend als Eloxieren bezeichnet wird und ein elektrolytisches Glänzen sowie eine anodische Oxydation umfasst, und aus der Aufbringung des optisch wirksamen Mehrschichtsystems im Vakuum.

Als Trägermaterial für Reflektoren mit hohem Gesamtreflexionsgrad wird weithin gewalztes Aluminium mit einer Mindestreinheit von 99,8 % verwendet, für das, da das Rohaluminium eine empfindliche Oberfläche hat, zum Erhalt der Gebrauchsfähigkeit die Zwischenschicht zum Schutz vor mechanischen und chemischen Einflüssen aufgebracht werden muss. Diese schützende Zwischenschicht entsteht in dem nasschemischen Eloxierprozess, wobei durch sie erreicht wird, dass die Oberfläche eine genügend geringe Rauigkeit und eine ausreichende Härte aufweist sowie defektfrei ausgebildet ist. Durch Änderungen der Reinheit und/oder der Rauheit kann dabei Einfluss auf die Höhe der Gesamtreflexion genommen werden, während durch gezielte Veränderungen der Walzstruktur des Aluminiumträgers ein Grad von diffuser Reflexion beeinflusst werden kann. Auf die Eloxalschicht wird eine hochreflektierende Reinstsilber-Schicht abgeschieden. Sie ist optisch dicht und weist im sichtbaren Bereich des Lichtes eine extrem hohe Gesamtreflexion auf.

Bei den mindestens zwei auf der Silberschicht befindlichen Schichten des optischen Mehrschichtsystems handelt es sich allgemein um dielektrische Schichten, wobei die Verwendung oxidischer Schichten, wie beispielsweise Aluminiumoxid oder Titanoxid als hochbrechende oberste Schicht und Siliciumdioxid als darunter liegende, niedriger brechende, auf der Silberschicht abgeschiedene Schicht, einen bevorzugten Sonderfall darstellt. Einzelheiten dazu sind beispielsweise auch der Beschreibung des bekannten MIRO®-Verfahrens, bei welchem allerdings als metallische Relexionsschicht Aluminium eingesetzt wird, aus "elektrowärme international" 53 (1995) B 4 - November, S. B 215-B 223 zu entnehmen.

Allgemein teilt sich bei einem Objekt, auf das eine Strahlung auftrifft, diese Strahlung in einen reflektierten, einen absorbierten und einen transmittierten Anteil auf, die durch den Reflexionsgrad (Reflexionsvermögen), den Absorptionsgrad (Absorptionsvermögen) und den Transmissionsgrad (Transmissionsvermögen) des Objektes bestimmt werden. Reflexionsvermögen, Absorptionsvermögen und Transmissionsvermögen sind optische Eigenschaften, die je nach der Wellenlänge einer einfallenden Strahlung (z. B. im Ultraviolett-Bereich, im Bereich des sichtbaren Lichts, im Infrarot-Bereich und im Bereich der Wärmestrahlung) für ein- und dasselbe Material unterschiedliche Werte annehmen können. Hinsichtlich des Absorptionsvermögens ist dabei das Kirchhoffsche Gesetz bekannt, wonach der Absorptionsgrad jeweils bei einer bestimmten Temperatur und Wellenlänge in konstantem Verhältnis zum Emissionsgrad steht. Somit sind für das Absorptionsvermögen auch das Wiensche Verschiebegesetz bzw. das Plancksche Gesetz sowie das Stefan-Boltzmann-Gesetz von Bedeutung, durch die bestimmte Zusammenhänge zwischen Strahlungsintensität, spektraler Verteilungsdichte, Wellenlänge und Temperatur eines so genannten "Schwarzen Körpers" beschrieben werden. Dabei ist bei Berechnungen zu beachten, dass der "Schwarze Körper" als solcher nicht existiert und reale Stoffe in je charakteristischer Weise von der Idealverteilung abweichen.

Bei dem bekannten Verbundmaterial spielt insbesondere das hohe Reflexionsvermögen im Bereich des sichtbaren Lichtes eine Rolle, das sich beispielsweise in einem nach DIN 5036, Teil 3 bestimmten Licht-Gesamtreflexionsgrad mit Spitzenwerten von bis zu über 98 Prozent ausdrückt. Außerdem ist bei dem bekannten Material, das vorzugsweise als Halbzeug geliefert wird, seine ausgezeichnete Verarbeitbarkeit, vor allem seine Verformbarkeit, hervorzuheben. Als problematisch, insbesondere bei Langzeitanwendungen und beim Einsatz in einer heißen Umgebung, wie in heißen Klimaten oder zusammen mit einem Leuchtmittel, welches eine starke Wärmeabstrahlung aufweist, hat es sich jedoch erwiesen, dass es bei dem Miro®-Siver-Material schneller als bei dem schon länger bekannten Miro®-Material, dessen metallische Reflexionsschicht aus Aluminium besteht, zu einem Verlust des Reflexionsvermögens kommen kann. Aufgrund des genannten Materialunterschieds wird als Ursache für diese Erscheinung eine mit Diffusionsvorgängen verbundene Korrosion des Silbers angesehen. Dabei ist davon auszugehen, dass ein elektrochemischer Potentialunterschied zwischen dem unedleren Aluminiumträger und der Reflexionsschicht aus Silber, welches als Edelmetall in der elektrochemischen Spannungsreihe ein größeres Standardpotential aufweist, als diffusionsfördernd anzusehen ist.

Aus der EP 1 867 934 A1 ist ein Verbundmaterial, insbesondere für ein Solarkollektorelement, bekannt, welches einen bandförmigen metallischen Träger, eine Zwischenschicht und ein auf die Zwischenschicht aufgebrachtes optisches Mehrschichtsystem umfasst, welches seinerseits eine metallische Infrarot-Reflektionsschicht und ein darüber liegendes Absorptions-Schichtsystem umfasst. Die Zwischenschicht ist zur elektrochemisch isolierenden Trennung des Trägers von dem optischen Mehrschichtsystem ohne durchgängige Poren ausgebildet und umfasst mindestens eine aus einem Kunststoff bestehende Teilschicht, wobei eine im Frequenzbereich von 1 bis 10 Hz an dem Verbund aus Träger und Schichten gemessene Impedanz einen Wert besitzt, der größer ist als 1 MΩ. Die Ermittlung der Impedanz wird dabei durch die sogenannte Impedanz-Spektroskopie vorgenommen. Der Verlauf der Impedanz, die über einen Frequenzbereich von etwa 1 Hz bis 10 Hz, optional bis zu etwa 100 kHz erfolgen kann, liefert, insbesondere mit dem dazugehörigen Phasendiagramm, sehr schnell eine Aussage, ob ein Verbundmaterial den Anforderungen genügen wird oder nicht. Ergänzend lässt sich auf diese Weise sehr schnell prüfen, ob eine applizierte Kunststoff-Teilschicht nach einer zum Zwecke der bevorzugten Aufbringung der Infrarot-Reflektionsschicht und des darüber liegenden Absorptions-Schichtsystems vorgenommenen Vakuumbehandlung das Verbundmaterial bezüglich seines späteren Korrosionsverhaltens verbessert oder verschlechtert hat.

Der vorliegenden Erfindung liegt die Aufgabe zugrunde, ein Verbundmaterial der eingangs beschriebenen Art mit hoher Reflektivität und daher einer besonderen Eignung für Reflexionssysteme zu schaffen, das langzeitlich, insbesondere bei gegenüber der Raumtemperatur (20 °C) erhöhter Temperatur, eine verringerte Einbuße des Licht-Gesamtreflexionsgrades aufweist und eine mechanisch hoch belastbare, d. h. insbesondere abrasionsresistente, Oberfläche aufweist. Diese Aufgabe wird erfindungsgemäß durch ein reflektierendes Verbundmaterial nach Anspruch 1 gelöst.

Vorteilhafte Ausgestaltungen sind in den Unteransprüchen definiert.

Durch die Barriereschicht wird mit Vorteil eine Wanderung von Silberteilchen - insbesondere wird eine Wanderung von Silberionen angenommen - durch gegebenenfalls noch vorhandene Poren der unter der Silberschicht liegenden anodisch oxidierten Schicht hindurch verhindert bzw. zumindest weitestgehend unterbunden. Dadurch kann zwischen der Silberschicht und dem Aluminiumträger kein korrosionsfördernd wirkendes Lokalelement entstehen, so dass der Licht-Gesamtreflexionsgrad langzeitlich stabil bleibt.

Insbesondere kann die Barriereschicht eine metallische oder nitridische Schicht sein, die vorzugsweise metallisches Chrom oder Nickel enthält, wobei, wenn die Barriereschicht aus Metall, insbesondere Chrom, besteht, die reflexive Wirkung des Schichtsystems sogar noch zusätzlich erhöht werden kann. Als möglicher Schichtkonstituent der Barriereschicht wird auch Palladium angesehen.

Die Barriereschicht enthält erfindungsgemäß - wie vorstehend ausgeführt - einen Stoff der chemischen Zusammensetzung $Cr_wNi_xN_yO_z$, wobei die Indizes w, x, y und z ein stöchiometrisches oder nichtstöchiometrisches Verhältnis bezeichnen, für das vorzugsweise gelten kann: $0 \leq w \leq 1$ und $0 \leq x \leq 1$, wobei mindestens einer der Indizes w oder x größer als Null ist, $0 \leq y \leq 1$, $0 \leq z \leq 5$. Durch die Formel sind dabei Chrom (x, y, z = 0), Nickel (w, y, z = 0), intermetallische Chrom-Nickel-Verbindungen (y, z = 0) sowie chrom- und/oder nickelnitridische (z = 0), -oxidische (y = 0) bzw. oxinitridische Verbindungen umfasst. Wenn der Index x = 0 ist, handelt es sich dabei vorzugsweise um eine nickelfreie, d. h. schwermetallfreie Schicht.

Durch die Erfindung wird vorteilhafterweise eine Schichtstruktur generiert, in der der Diffusionsweg des Silbers auf den Aluminiumträger hin zusätzlich verstellt ist. Die Barriereschicht kann dabei bevorzugt - insbesondere im Fall einer metallischen Chromschicht - eine Dicke im Bereich von 50 nm bis 150 nm aufweisen. Allgemein kann die Dicke der Barriereschicht jedoch im Bereich von 5 nm bis 500 nm liegen, wobei ein Bereich von 10 nm bis 200 nm bevorzugt und ein Bereich von 15 nm bis 70 nm besonders bevorzugt ist.

Alternativ oder zusätzlich wird einer auf das optische Mehrschichtsystem als siliciumoxidische und/oder siliciumnitridische Deckschicht aufgebrachten Mischschicht der chemischen Zusammensetzung $Si_aC_bO_cN_dH_e$ erfinderische Bedeutung zugemessen, wobei die Indizes a, b, c, d und e ein stöchiometrisches oder nichtstöchiometrisches Verhältnis bezeichnen und derart eingestellt sind, dass die Deckschicht bei einer gewählten Schichtdicke nur eine geringe Lichtabsorption, insbesondere eine Lichtabsorption von weniger als 10 Prozent, aufweist wobei der Kohlenstoffgehalt - bezogen auf die Gesamtmasse der Deckschicht (7) - im Bereich von 0 Atomprozent bis 15,0 Atomprozent liegt.

Nach dem ersten Fick'schen Gesetz ist bei einer Diffusion die Teilchenstromdichte (Fluss) $J$ (mol m$^{-2}$ s$^{-1}$) proportional zum Konzentrationsgradienten (Triebkraft) $\partial c/\partial x$ (mol·m$^{-4}$) entgegen der Diffusionsrichtung. Die Proportionalitätskonstante ist der Diffusionskoeffizient $D$ (m$^2$ s$^{-1}$).

$$J = -D\frac{\partial c}{\partial x}$$

Der Diffusionskoeffizient ist somit ein Maß für die Beweglichkeit der Teilchen und lässt sich aus dem durchschnittlichen Quadrat der zurückgelegten Wegstrecke pro Zeit ermitteln. Für die Diffusion in Festkörpern sind Sprünge zwischen verschiedenen Gitterplätzen erforderlich. Dabei müssen die Teilchen eine Energiebarriere E überwinden, was bei höherer Temperatur leichter möglich ist als bei niedrigerer. Dies wird beschrieben durch den Zusammenhang:

$$D = D_0 \cdot \exp\left(-\frac{E}{R \cdot T}\right)$$

mit

$E$ - Energiebarriere (in J·mol$^{-1}$)
$R$ - allgemeine Gaskonstante (in J·K$^{-1}$mol$^{-1}$)
$T$ - Temperatur (in K).

Durch die Barriereschicht wird der Diffusionskoeffizient des Silbers abgesenkt. Die Verringerung des Diffusionskoeffizienten ist dabei darauf zurückzuführen, dass die Energiebarriere E, welche die Silberteilchen in der Barriereschicht zum Wechsel zwischen verschiedenen Gitterplätzen überwinden müssen, größer ist als die Energiebarriere E in der anodisch oxidierten Eloxalschicht. Eine Teilchenwanderung nach unten - auf den Träger hin - durch Poren der unter der Silberschicht liegenden anodisch oxidierten Schicht oder durch das Aluminiumoxid der Schicht selbst wird somit im Sinne des ersten Diffusionsgesetzes inhibiert. Eine, insbesondere bei gegenüber Raumtemperatur erhöhter Temperatur unter Beachtung der oben angegebenen Beziehung erfolgende Alterung, die sich in einem Abfall der Licht-Gesamtreflexion äußert, wird dadurch mit Vorteil extremal verzögert.

Die anodisch oxidierte Schicht ist dabei - auch, wenn sie nicht an der Oberfläche liegt - zusammen mit der Barriereschicht, der Haftvermittlerschicht und dem optischen Mehrschichtsystem von großer Wichtigkeit zur Einstellung einer hohen Kratz- bzw. Wischfestigkeit sowie für die Korrosionsbeständigkeit des erfindungsgemäßen Verbundmaterials.

Poren der Aluminiumoxidschicht können in der letzten Phase der nasschemischen Prozesskette weitestgehend durch eine mit Wasserdampf erfolgende Heißverdichtung verschlossen werden, so dass auf dem Träger eine dauerhaft beständige Oberfläche entsteht. Dies wirkt zusätzlich diffusionshemmend. Durch den Aluminiumträger kann dabei - auch für die Eloxalschicht, deren Dicke bevorzugt im Bereich von 0,01 $\mu$m bis 10,0 $\mu$m, bevorzugt im Bereich von 0,5 $\mu$m bis 2,0 $\mu$m, besonders bevorzugt im Bereich von 0,7 $\mu$m bis 1,5 $\mu$m, liegen kann - eine ausgezeichnete Verformbarkeit gewährleistet werden, mit der das erfindungsgemäße Verbundmaterial Beanspruchungen von Weiterverarbeitern bei vorzunehmenden Formgebungsprozessen ohne Probleme widersteht. Hervorzuheben sind dabei auch die hohe Wärmeleitfähigkeit des Trägers sowie die Fähigkeit zu einer im solaren Wellenlängenbereich reflexionsfördernden bzw. der Anteile von diffuser und gerichteter Reflexion variablen Oberflächengestaltung, der die anderen Schichten dann im Relief folgen.

Das erfindungsgemäße Verbundmaterial kann eine Ausbildung als Coil - insbesondere mit einer Breite bis zu 1400 mm, vorzugsweise bis zu 1600 mm, aufweisen. Ein derartiges erfindungsgemäßes Reflektormaterial aus Aluminiumband ist dabei verformbar, ohne dass die optischen, mechanischen und chemischen Materialeigenschaften beeinträchtigt werden.

Um die Haftung der bei der Herstellung des Verbundmaterials auf der Barriereschicht abzuscheidenden Silberschicht auf den Materialien der Barriereschicht, insbesondere auf Chrom, zu verbessern, ist die Haftvermittlerschicht vorgesehen. Dabei sollte insbesondere ein oxidischer Haftvermittler, wie vorzugsweise Al$_2$O$_3$, TiO$_2$ oder CrO$_s$, eingesetzt werden, der eine geringe Reaktivität gegenüber dem Silber aufweist, wobei s wiederum ein stöchiometrisches oder nichtstöchiometrisches Verhältnis bezeichnet. Die Schichtdicke der Haftvermittlerschicht kann dabei im Bereich von 1 nm bis 50 nm, bevorzugt im Bereich von 5 nm bis 25 nm, besonders bevorzugt im Bereich von 10 nm bis 20 nm, liegen.

Die Dicke der Reflexionsschicht kann im Bereich von 30 nm bis 200 nm liegen. Dies sichert im Sinne der eingangs genannten physikalischen Zusammenhänge eine geringe Transmission und hohe Reflexion der elektromagnetischen Strahlung. Die Silberschicht kann - wie auch alle anderen beschriebenen Schichten - dabei auch aus Teilschichten gebildet sein. Als bevorzugte Dicke der Silberschicht wird eine solche im Bereich von 40 nm bis 150 nm und als besonders bevorzugte Dicke im Bereich von 50 nm bis 100 nm angesehen.

Die Barriereschicht, die Haftvermittlerschicht sowie die Schichten des optischen Mehrschichtsystems können Sputterschichten, insbesondere durch Reaktivsputtern erzeugte Schichten, CVD- (Chemical Vapor Deposition) oder PE-CVD- (Plasma Enhanced Chemical Vapor Deposition) Schichten oder durch Verdampfen, insbesondere durch Elektronenbombardement oder aus thermischen Quellen, erzeugte Schichten sein, so dass das gesamte auf der Zwischenschicht befindliche Mehrschichtsystem in prozesstechnisch optimaler Weise aus in Vakuumfolge, insbesondere in einem kontinuierlichen Verfahren, aufgetragenen Schichten besteht. Die genannten Verfahren gestatten es vorteilhafterweise dabei, die chemische Zusammensetzung der Schichten hinsichtlich der Indizes w, x, y und z nicht nur auf bestimmte, diskrete Werte einzustellen, sondern das stöchiometrische oder nichtstöchiometrische Verhältnis jeweils innerhalb bestimmter Grenzen fließend zu variieren.

Auf diese Weise können beispielsweise auch die jeweiligen Brechungsindizes der beiden oberen Schichten, welche in ihrer Paarung ein Ansteigen der Reflexion bewirken, wenn die oberste Schicht einen höheren Brechungsindex als die darunterliegende aufweist, gezielt eingestellt werden. Das Material der beiden über der Silberschicht liegenden Schichten kann chemisch der Gruppe der Metalloxide, -fluoride, -nitride oder -sulfide oder deren Mischungen zugehörig sein, wobei die Schichten unterschiedliche Brechungsindizes aufweisen. So kann eine Differenz der Brechungsindizes - bezogen auf eine Wellenlänge von 550 nm - beispielsweise größer als 0,10, bevorzugt größer als 0,20, sein. Als Materialien der obersten, hochbrechenden Schicht können dabei insbesondere $Ta_2O_5$, $Nb_2O_5$, $MoO_3$, $TiO_2$ und $ZrO_2$ und als Materialien der darunter liegenden, niedriger brechenden Schicht $Al_2O_3$ und $SiO_2$ zur Anwendung kommen.

Bezüglich der Indizes des Sauerstoffs in den vorgenannten Oxiden, insbesondere bezüglich des Index "2" des $TiO_2$, gilt dabei, dass die oxidischen Schichten nicht zwingend vollständig stöchiometrisch sein müssen, sondern auch als anderes Oxid oder Suboxid vorliegen könnten, sofern diese weiterhin die nahezu gleiche hohe Lichttransparenz wie die stöchiometrisch aufgebauten Oxide haben.

Die jeweilige optische Dicke der oberen und der mittleren Schicht des optischen Schichtsystems sollte vorzugsweise - damit die Schichten als reflexionserhöhende Interferenzschichten wirken können - so bemessen sein, dass sie etwa ein Viertel der Mittenwellenlänge des Spektralbereiches der zu reflektierenden elektromagnetischen Strahlung beträgt.

Die obere, hochbrechende dielektrische Schicht kann insbesondere eine Dicke im Bereich von 30 nm bis 200 nm, bevorzugt im Bereich von 40 nm bis 100nm, besonders bevorzugt im Bereich von 45 nm bis 65 nm, aufweisen.

Die darunter liegende, niedriger brechende dielektrische Schicht kann insbesondere eine Dicke im Bereich von 30 nm bis 200 nm, bevorzugt im Bereich von 40 nm bis 100 nm, besonders bevorzugt im Bereich von 50 nm bis 70 nm, aufweisen.

Zur Haftungsverbesserung auf der Silberschicht bzw. Verhinderung einer Delamination der niedrigbrechenden Schicht von der Silberschicht kann eine weitere Haftvermittlerschicht vorgesehen sein, die ebenfalls insbesondere oxidisch ist und vorzugsweise aus $CrO_s$ bestehen kann. Die zweite Haftvermittlerschicht kann dabei prinzipiell eine Dicke aufweisen, die im gleichen Bereich liegt, wie die der ersten Haftvermittlerschicht. Typischerweise sollte sie jedoch eine möglichst derartig minimal gewählte Dicke aufweisen, dass bei ausreichender Haftungsvermittlung durch die Schicht durch sie nur eine möglichst geringe Absorption bewirkt wird.

Über der hochbrechenden oberen Schicht des optischen Mehrschichtsystems kann als zusätzliche vierte Schicht auch noch, eine insbesondere siliciumoxidische und/oder -nitridische Deckschicht angeordnet sein, die ein hohes Transmissionsvermögen aufweist und die mechanische und Korrosionsbeständigkeit verbessert. Eine hervorragende Haftung ist zu erreichen, wenn eine unmittelbar unter der Deckschicht liegende dielektrische Schicht eine in einem PVD- (Physical Vapor Deposition) Verfahren aufgebrachte $Nb_2O_5$ und $Ta_2O_5$-Schicht ist, wobei dies auch eine hohe Härte und Elastizität des erfindungsgemäßen Verbundmaterials fördert. Alternativ empfiehlt sich eine Titandioxidschicht. Die Deckschicht des optischen Mehrschichtsystems kann dabei mit Vorteil eine Mindestdicke von 3 nm aufweisen.

Insbesondere ab einer Dicke von 5 nm bis 20 nm besitzt die Schicht bereits eine signifikante Effizienz hinsichtlich ihrer Schutzwirkung, wobei Zeit-, Material- und Energieaufwand nur geringe Werte annehmen. Ein oberer Grenzwert der Schichtdicke liegt unter diesem Gesichtspunkt bei etwa 500 nm.

Weitere vorteilhafte Ausführungen der Erfindung sind in den Unteransprüchen und in der nachfolgenden detaillierten Beschreibung enthalten.

Anhand eines durch die beiliegende Zeichnung veranschaulichten Ausführungsbeispiels wird die Erfindung näher erläutert.

Dabei zeigen:

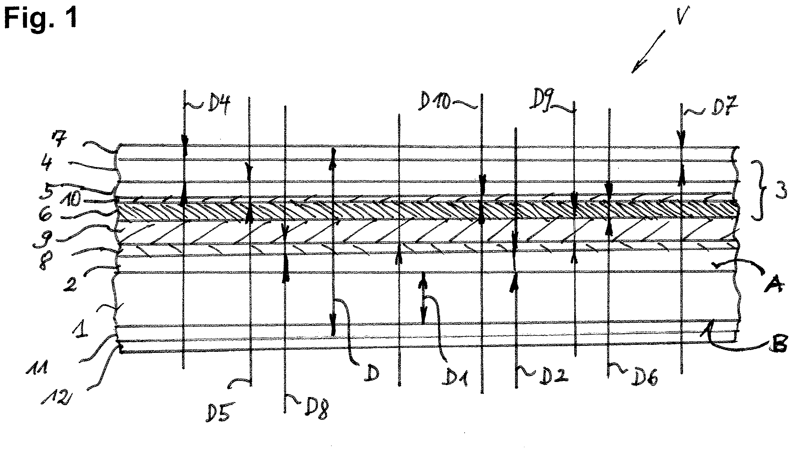

Fig. 1    eine prinzipielle Schnittdarstellung durch ein erfindungsgemäßes Verbundmaterial, wobei die darin enthaltenen Schichtdicken rein schematisch und nicht maßstabsgerecht dargestellt sind,

Fig. 2    eine vergleichende diagrammatische Darstellung des Reflexionsgrades über einer Testzeit von nicht erfindungsgemäßen und erfindungsgemäßen Verbundmaterial-Proben.

Die beschriebene Ausführung betrifft ein erfindungsgemäßes Verbundmaterial V mit einem hohen Reflexionsgrad, insbesondere im solaren Wellenlängenbereich. Es kann bevorzugt zur Reflexion optischer Strahlung - also elektromagnetischer Strahlung im Wellenlängenbereich von 100 nm bis 1 mm - eingesetzt werden.

Das Verbundmaterial V besteht aus einem, insbesondere verformungsfähigen, bandförmigen Träger 1 aus Aluminium, einer auf einer Seite A des Trägers 1 befindlichen Zwischenschicht 2 und einem auf die Zwischenschicht 2 aufgebrachten optisch wirksamen Mehrschichtsystem 3.

Ein nach DIN 5036, Teil 3 bestimmter Licht-Gesamtreflexionsgrad beträgt auf der Seite A des optischen Mehrschichtsystems 3 mehr als 95 %, vorzugsweise mindestens 97 %, besonders bevorzugt mindestens 98 %.

Das Verbundmaterial V kann bevorzugt als Coil mit einer Breite bis zu 1600 mm, vorzugsweise von 1400 mm, und - einschließlich eventuell vorhandener Schichten auf seiner Rückseite B - mit einer Dicke D von etwa 0,2 mm bis 1,7 mm, vorzugsweise von etwa 0,3 bis 0,8 mm, besonders bevorzugt 0,4 mm bis 0,7 mm ausgebildet sein. Der Träger 1 allein kann dabei bevorzugt eine Dicke D1 im Bereich von 0,2 mm bis 0,6 mm besitzen.

Das Aluminium des Trägers 1 kann insbesondere eine höhere Reinheit als 99,0 % aufweisen, wodurch seine Wärmeleitfähigkeit gefördert wird. Dadurch kann die Entstehung von Wärmepeaks verhindert und somit der Diffusionskoeffizient klein gehalten werden. Beispielsweise kann es sich bei dem Träger 1 aber auch um ein bandförmiges Aluminiumblech Al 98,3 (Reinheit 98,3 Prozent) mit einer Dicke D1 von 0,5 mm handeln. Die Mindestdicke D1 eines solchen Bleches kann bei 100 $\mu$m liegen, während die obere Grenze - der Dicke D1 etwa bei 1,5 mm liegen kann. Es ist auch möglich, als Träger 1 Aluminiumlegierungen, wie beispielsweise eine AlMg-Legierung, einzusetzen, insofern daraus durch anodische Oxidation die Zwischenschicht 2 gebildet werden kann.

Die Zwischenschicht 2 besteht aus anodisch oxidiertem Aluminium, das aus dem Trägermaterial gebildet ist, und kann eine Dicke D2 im Bereich von 10 nm bis 10,0 $\mu$m, vorzugsweise im Bereich von 500 nm bis 2,0 $\mu$m, besonders bevorzugt im Bereich von 700 nm bis 1,5 $\mu$m, aufweisen. Sie kann auf nasschemischem Weg erzeugt werden, wobei die Poren der Aluminiumoxidschicht in der letzten Phase der Prozesskette weitestgehend durch eine Heißverdichtung verschlossen werden können.

Hierbei ist es bevorzugt, dass die Oberfläche der Zwischenschicht 2 einen arithmetischen Mittenrauhwert $R_a$ im Bereich von weniger als 0,05 $\mu$m, insbesondere von weniger als 0,01 $\mu$m, besonders bevorzugt von weniger als 0,005 $\mu$m, aufweist. Dies dient bei Vorliegen des vorstehend genannten hohen Licht-Gesamtreflexionsgrades zur Einstellung eines nach DIN 5036 bestimmten, minimalen, diffusen Licht-Reflexionsgrades. Ist ein höherer diffuser Licht-Reflexionsgrad gefordert, kann die Rauheit entsprechend erhöht werden.

Das optische Mehrschichtsystem 3 umfasst mindestens drei Schichten 4, 5, 6 wobei die oberen Schichten 4, 5 dielektrische und/oder oxidische Schichten sind, und die unterste Schicht 6 eine metallische, aus Silber bestehende, Schicht ist, welche eine Reflexionsschicht 6 bildet. Die jeweilige optische Dicke D4, D5 der oberen und der mittleren Schicht 4, 5 des optischen Schichtsystems 3 sollte - damit die Schichten 4, 5 als reflexionserhöhende Interferenzschichten wirken können - so bemessen sein, dass sie etwa ein Viertel der Mittenwellenlänge des Spektralbereiches der zu reflektierenden elektromagnetischen Strahlung beträgt. Die Dicke D6 der Reflexionsschicht 6 kann bevorzugt im Bereich von 40 nm bis 150 nm liegen.

Auf der oberen Schicht 4 des optischen Mehrschichtsystems 3 ist in der dargestellten Ausführung eine optional vorhandene siliciumoxidische Deckschicht 7 mit einer Dicke D7 aufgetragen. Es kann auch vorgesehen sein, dass auf das optische Mehrschichtsystem 3 eine siliciumnitridische oder siliciumoxynitridische Schicht 7 aufgebracht ist. Das optische Mehrschichtsystem 3 - einschließlich der Deckschicht 7 - kann in technologisch vorteilhafter Weise unter Anwendung eines kontinuierlichen Vakuum-Bandbeschichtungsprozesses appliziert werden.

Ebenso kann es sich bei der - entweder optional zusätzlich, aber auch alternativ erfindungsgemäß, d. h. ohne die spezielle Zusammensetzung der Barriereschicht aus Palladium oder aus $Cr_wNi_xN_yO_z$ - vorhandenen Deckschicht 7 um eine Mischschicht der chemischen Zusammensetzung $Si_aC_bO_cN_dH_e$ handeln, wobei die Indizes a, b, c, d und e ein stöchiometrisches oder nichtstöchiometrisches Verhältnis bezeichnen und derart eingestellt sind, dass die Deckschicht 7 bei einer gewählten Schichtdicke D7 nur eine geringe Lichtabsorption, insbesondere eine Lichtabsorption von < 10 %, bevorzugt von < 5 %, besonders bevorzugt von < 1 %, aufweist, und wobei der Kohlenstoffgehalt - bezogen auf die Gesamtmasse der Deckschicht 7 - im Bereich von 0 Atom-%, insbesondere von 0,2 Atom-%, bis 15,0 Atom-%, bevorzugt im Bereich von 0,8 Atom-% bis 4,0 Atom-%, liegt. Für einen Index a = 1 können dann die anderen Indizes in folgenden Bereichen liegen: $0 \leq b \leq 2$, $0 \leq c \leq 2$, $0 \leq d \leq 4/3$, $0 \leq e \leq 1$. Mindestens einer der Indizes b, c, d sollte dabei von Null verschieden sein. Eine derartige Schicht kann insbesondere als CVD-Schicht, bevorzugt als PE-CVD Schicht, aufgebracht werden, wobei der Vorteil ihres Einsatzes darin besteht, dass sie gegen korrosive Medien als Barriereschicht wirkt, wobei insbesondere durch den Anteil an Kohlenstoff eine höhere Flexibilität und Zähigkeit der Schicht eingestellt werden kann als bei rein keramischen $SiO_2$-Schichten.

Es kann auch vorgesehen sein, dass auf das optische Mehrschichtsystem 3 als Deckschicht 7 eine siliciumorganische Lackschicht auf Basis einer Sol-Gel-Schicht mit einer bevorzugten Schichtdicke im Bereich von 0,5 $\mu$m bis 5 $\mu$m aufgebracht ist.

Um bei einem Langzeiteinsatz des erfindungsgemäßen Verbundmaterials und/oder bei erhöhter Temperatur eine verringerte Einbuße des Licht-Gesamtreflexionsgrades zu erreichen, also den Alterungsprozess zu verlangsamen, ist erfindungsgemäß über der Zwischenschicht 2 und unter der Reflexionsschicht 6 eine diffusionshemmende Barriereschicht 8 angeordnet. Die Reflexionsschicht 6 ist über eine Haftvermittlerschicht 9 an die Barriereschicht 8 angebunden. Wie bereits erwähnt, kann die Barriereschicht 8 eine metallische oder nitridische Schicht sein, wobei insbesondere metallisches Chrom als bevorzugt angesehen wird.

Allgemein ausgedrückt kann die Barriereschicht 8 mit Vorteil einen Stoff mit der chemischen Formel $Cr_wNi_xN_yO_z$ enthalten oder gänzlich daraus bestehen. Die Indizes w, x, y und z bezeichnen darin ein stöchiometrisches oder nichtstöchiometrisches Verhältnis, für das vorzugsweise gelten kann: $0 \leq w \leq 1$ und $0 \leq x \leq 1$, wobei mindestens einer der Indizes w oder x größer als Null ist, $0 \leq y \leq 1$, $0 \leq z \leq 5$. Die Barriereschicht 8 kann bevorzugt eine Dicke D8 im Bereich von 10 nm bis 200 nm aufweisen. Im Fall einer Chromnitridschicht kann eine minimale Dicke D8 insbesondere bei 40 nm liegen. In der Barriereschicht 8 ist der Diffusionskoeffizient des diffundierenden Silbers im Vergleich zur Diffusion in Aluminiumoxid stark herabgesetzt.

Die Haftvermittlerschicht 9 ist vorgesehen, um die Adhäsion der aus Silber bestehenden Reflexionsschicht 6 auf der Barriereschicht 8 zu erhöhen. Als geeignete Schichtmaterialien sind dabei insbesondere oxidische Haftvermittler, wie vorzugsweise $Al_2O_3$, $TiO_2$ oder $CrO_s$, anzusehen, wobei s wiederum ein stöchiometrisches oder nichtstöchiometrisches Verhältnis bezeichnet und im Bereich $0 < s < 1,5$ liegen sollte. Die Schichtdicke D9 der Haftvermittlerschicht kann dabei im Bereich von 1 nm bis 50 nm, bevorzugt im Bereich von 5 nm bis 25 nm, liegen. Als besonders bevorzugt wird ein Bereich zwischen 10 nm bis 20 nm angesehen.

Zur Haftungsverbesserung und Verhinderung einer Delamination der niedriger brechenden Schicht 5 auf bzw. von der Silberschicht 6 kann - wie dargestellt - eine weitere Haftvermittlerschicht 10 vorgesehen sein, die ebenfalls insbesondere oxidisch ist und vorzugsweise aus $CrO_s$ bestehen kann. Die zweite Haftvermittlerschicht 10, welche aufgrund ihrer Lage dem optischen Mehrschichtsystem 3 zuzuordnen ist, kann dabei eine Dicke D10 aufweisen, die im Bereich von 0,1 bis 10 nm, bevorzugt im Bereich von 0,5 bis 5 nm, liegt. Von den chromoxidischen, insbesondere gegenüber dreiwertigem Chrom unterstöchiometrischen $CrO_s$-Verbindungen, ist eine lichtabsorptive Wirkung bekannt. Jedoch mindert diese Wirkung den hohen Licht-Gesamtreflexionsgrad insbesondere dann nur marginal, wenn Dicke D10 im angegebenen Vorzugsbereich liegt.

Die Barriereschicht 8 und die Haftvermittlerschichten 9, 10 können - wie die Schichten 4, 5, 6 des optischen Mehrschichtsystems - Sputterschichten, insbesondere durch Reaktivsputtern erzeugte Schichten, CVD- oder PE-CVD-Schichten oder durch Verdampfen, insbesondere durch Elektronenbombardement oder aus thermischen Quellen, erzeugte Schichten sein, so dass das gesamte auf der Zwischenschicht befindliche Mehrschichtsystem aus in Vakuumfolge, insbesondere in einem kontinuierlichen Verfahren, aufgetragenen Schichten besteht.

Zu einem hohen Kratzschutz tragen alle Schichten des erfindungsgemäßen Verbundmaterials V sowie die hohe Adhäsion zwischen ihnen bei. Insbesondere leisten in einem synergistischen Zusammenwirken dazu sowohl die vergleichsweise dickere und härtere Eloxalschicht 2, als auch die darüber liegenden, vergleichsweise dünneren und weniger harten dielektrischen Schichten einen Beitrag. Dies drückt sich beispielsweise in einer hohen Wischbeständigkeit aus, welche in einem Wischtest nach der derzeit geltenden Norm DIN ISO 9211-4:2012, welche die frühere DIN 58196 ersetzt hat, ermittelt werden kann. Hierin sind in der Tabelle 1 der genannten Norm die nachfolgend aufgeführten Schärfegrade angegeben.

Tabelle 1 - Schärfegrade für Beanspruchungsart 01: Abrieb

| Schärfegrad | 01 | 02 | 03 | 04 |
|---|---|---|---|---|
| Prüfkopf | Baumwolltuch | Baumwolltuch | Radiergummi | Radiergummi |
| Anzahl Hubbewegungen | 50 | 100 | 20 | 40 |
| Kraft | 5 N ± 1 N | 5 N ± 1 N | 10N ± 1 N | 10 N ± 1 N |

Abweichend von dieser Tabelle wurde das erfindungsgemäße Verbundmaterial V (ohne die optionale Deckschicht 7) mit Filztuch statt mit Baumwolltuch getestet. Nach 100 Wischhüben mit einer Filzoberfläche war dabei keine Beschädigung der Oberfläche sichtbar.

Generell sind, wenn zu den zitierten Normen kein Datum genannt ist, die entsprechend zum Anmeldezeitpunkt geltenden Fassungen von Bedeutung.

Die erfindungsgemäß erzielbare Eigenschaftsverbesserung drückte sich darin aus, dass nach mindestens 168 h Belastung bei erhöhter Temperatur (≥ 50 °C) keine optische Veränderung der Oberfläche bzw. eine Abnahme der Licht-Gesamtreflexion von weniger als 1 % (für LED Anwendungen nach DIN 5036-3) bzw. eine Abnahme der solar gewichteten Gesamtreflexion von weniger als 1 % (für solare Anwendungen mit dem solaren Spektrum AM1.5 aus ASTM G173-03) eintrat, nachdem das erfindungsgemäße Verbundmaterial entsprechend der Norm DIN ISO 9211-4:2006 einer UV-B Strahlung in Kombination mit einer Kondensation ausgesetzt wurde. Gleiches gilt für einen Test nach der derzeit geltenden Fassung der amerikanischen Prüfvorschrift ASTM D4585 "Testing Moisture Resistance of coatings with Controlled Condensation", wonach das erfindungsgemäße Verbundmaterial unter den von der Norm festgelegten Bedingungen einer reinen Kondensation ohne Bestrahlung ausgesetzt wurde. Von dem eingangs beschriebenen bekannten nicht erfindungsgemäßen Material wurden diese Werte nicht erreicht.

Für die nachfolgend dargestellten Vergleichs- und erfindungsgemäßen Beispiele wurde ein Solarsimulator nach ASTM E-927-85 "Standard Specification for Solar Simulation for Terrestrial Photovoltaic Testing", "Type Class A" mit einer gemessenen UV-A und UV-B Gesamtintensität auf der Probenoberfläche im Bereich von 70 mW/cm² bis 150 mW/cm² eingesetzt. Hierbei wurde als Randbedingung eingehalten, dass die jeweilige Probe so temperiert wurde, dass die gemessene Temperatur auf der Probenoberfläche im Bereich von ≥ 150 °C lag. Das jeweilig untersuchte Muster hatte den Test dann bestanden, wenn die Abnahme der Licht-Gesamtreflexion Y (D65) geringer war als 1 % (für LED Anwendungen nach DIN 5036-3), oder wenn die Abnahme der solar gewichteten Gesamtreflexion $R_{solar}$ geringer war als 1 % (für solare Anwendungen mit dem solaren Spektrum AM1.5 aus ASTM G173-03). Da es sich in beiden Fällen um in Prozenten angegebene Reflexionsgrößen handelt, wird für den Abfall der jeweiligen Größen einheitlich das Bezugszeichen ∆R verwendet. Für eine nicht über dieses Maß hinausgehende Reflexionsänderung ∆R beträgt die zu bestehende Belastungsdauer im Falle einer UV-Gesamtintensität von 150 mW/cm$^2$ mindestens 500 h, wohingegen bei einer UV-Gesamtintensität von 70 mW/cm$^2$ mindestens 1000 h erreicht werden müssen.

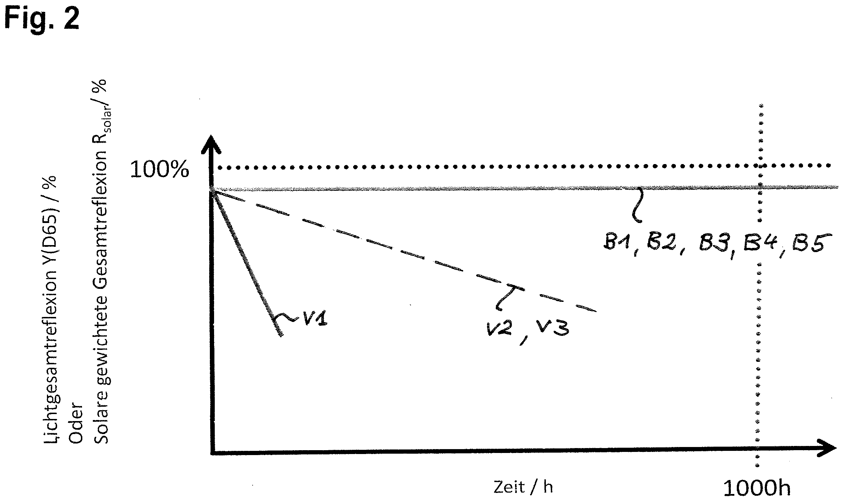

Die Schichtdicken der nachfolgend unter Bezug auf Fig. 2 dargestellten Vergleichsbeispiele und erfindungsgemäßen Beispiele lagen jeweils in den oben als bevorzugt bzw. - falls angegeben - als besonders bevorzugt genannten Bereichen.

Vergleichsbeispiel 1 (Bezugszeichen V1 in Fig. 2)

Schichtsystem (von unten nach oben):

Träger 1: Aluminium
Zwischenschicht 2: Eloxal
Haftvermittlerschicht zwischen Zwischenschicht 2 und Reflexionsschicht 6: $TiO_2$
Barriereschicht 8: keine
Reflexionsschicht 6: Silber
untere dielektrische Schicht 5: $Al_2O_3$
obere dielektrische Schicht 4: $Nb_2O_5$

Die über der Zwischenschicht 2 befindlichen dielektrischen Schichten 4, 5 wurden mittels Elektronenstrahlverdampfung aufgebracht.

Nach 72 Stunden betrug der Abfall ∆R des Reflexionsgrades mehr als 4 %. Der Test wurde nicht bestanden.

Vergleichsbeispiel 2 (Miro® Silver, Bezugszeichen V2 in Fig. 2)

Schichtsystem (von unten nach oben):

Träger 1: Aluminium
Zwischenschicht 2: Eloxal
Haftvermittlerschicht zwischen Zwischenschicht 2 und Reflexionsschicht 6: $TiO_2$
Barriereschicht 8: keine
Reflexionsschicht 6: Silber
untere dielektrische Schicht 5: $Al_2O_3$
obere dielektrische Schicht 4: $TiO_2$

Die über der Zwischenschicht 2 befindlichen dielektrischen Schichten 4, 5 wurden mittels Elektronenstrahlverdampfung aufgebracht.

Nach 336 Stunden betrug der Abfall ∆R des Reflexionsgrades mehr als 1 %. Der Test wurde nicht bestanden.

Vergleichsbeispiel 3 (Bezugszeichen V3 in Fig. 2)

Schichtsystem (von unten nach oben):

Träger 1: Aluminium
Zwischenschicht 2: Eloxal
Haftvermittlerschicht zwischen Zwischenschicht 2 und Reflexionsschicht 6: $TiO_2$
Barriereschicht 8: keine
Reflexionsschicht 6: Silber
untere dielektrische Schicht 5: $SiO_2$
obere dielektrische Schicht 4: $TiO_2$

Die über der Zwischenschicht 2 befindlichen dielektrischen Schichten 4, 5 wurden mittels Elektronenstrahlverdampfung aufgebracht.

Nach 336 Stunden betrug der Abfall $\Delta R$ des Reflexionsgrades mehr als 1 %. Der Test wurde nicht bestanden.

Beispiel 1 (erfindungsgemäß, Bezugzeichen B1 in Fig. 2)

Schichtsystem (von unten nach oben):

Träger 1: Aluminium
Zwischenschicht 2: Eloxal
Barriereschicht 8: metallisches Chrom
Haftvermittlerschicht 9 zwischen Barriereschicht 8 und Reflexionsschicht 6: $TiO_2$
Reflexionsschicht 6: Silber
untere dielektrische Schicht 5: $Al_2O_3$
obere dielektrische Schicht 4: $Nb_2O_5$

Die über der Zwischenschicht 2 befindliche untere dielektrische $Al_2O_3$-Schicht 5 wurde mittels Elektronenstrahlverdampfung aufgebracht, während die obere dielektrische $Nb_2O_5$-Schicht 4 mittels Magnetronsputterbeschichtung aufgebracht wurde.
Nach 1000 Stunden betrug der Abfall $\Delta R$ des Reflexionsgrades weniger als 1 %. Der Test wurde bestanden.

Beispiel 2 (erfindungsgemäß, Bezugzeichen B2 in Fig. 2)

Schichtsystem (von unten nach oben):

Träger 1: Aluminium
Zwischenschicht 2: Eloxal
Barriereschicht 8: metallisches Chrom
Haftvermittlerschicht 9 zwischen Barriereschicht 8 und Reflexionsschicht 6: $TiO_2$
Reflexionsschicht 6: Silber
untere dielektrische Schicht 5: $Al_2O_3$
obere dielektrische Schicht 4: $TiO_2$

Die über der Zwischenschicht 2 befindliche untere dielektrische $Al_2O_3$-Schicht 5 wurde mittels Elektronenstrahlverdampfung aufgebracht, während die obere dielektrische $TiO_2$-Schicht 4 mittels Magnetronsputterbeschichtung aufgebracht wurde.
Nach 1000 Stunden betrug der Abfall $\Delta R$ des Reflexionsgrades weniger als 1 %. Der Test wurde bestanden.

Beispiel 3 (erfindungsgemäß, Bezugzeichen B3 in Fig. 2)

Schichtsystem (von unten nach oben):

Träger 1: Aluminium
Zwischenschicht 2: Eloxal
Barriereschicht 8: metallisches Chrom
Haftvermittlerschicht 9 zwischen Barriereschicht 8 und Reflexionsschicht 6: $TiO_2$
Reflexionsschicht 6: Silber
untere dielektrische Schicht 5: $SiO_2$
obere dielektrische Schicht 4: $Nb_2O_5$

Die über der Zwischenschicht 2 befindliche untere dielektrische $SiO_2$-Schicht 5 wurde mittels plasmaunterstützter chemischer Dampfphasenabscheidung (PE-CVD) aufgebracht, während die obere dielektrische $Nb_2O_5$-Schicht 4 mittels Magnetronsputterbeschichtung aufgebracht wurde.
Nach 1000 Stunden betrug der Abfall $\Delta R$ des Reflexionsgrades weniger als 1 %. Der Test wurde bestanden.

Beispiel 4 (erfindungsgemäß, Bezugsbezeichnung B4 in Fig.2)

Schichtsystem (von unten nach oben):

Träger 1: Aluminium

Zwischenschicht 2: Eloxal

Barriereschicht 8: metallisches $Ni_{80}Cr_{20}$ (80:20 Gewichtsprozent) Haftvermittlerschicht 9 zwischen Barriereschicht 8 und Reflexionsschicht 6: $TiO_2$ Reflexionsschicht 6: Silber

Haftvermittlerschicht 10 zwischen Reflexionsschicht 6 und dielektrischer Schicht 5: $CrO_s$

untere dielektrische Schicht 5: $Al_2O_3$

obere dielektrische Schicht 4: $Nb_2O_5$

Die über der Zwischenschicht 2 befindliche untere dielektrische $Al_2O_3$-Schicht 5 wurde mittels Elektronenstrahlverdampfung aufgebracht, während die obere dielektrische $Nb_2O_5$-Schicht 4 mittels Magnetronsputterbeschichtung aufgebracht wurde.

Nach 1000 Stunden betrug der Abfall $\Delta R$ des Reflexionsgrades weniger als 1%. Der Test wurde bestanden.

Beispiel 5 (erfindungsgemäß, Bezugsbezeichnung B5 in Fig.2)

Schichtsystem (von unten nach oben):

Träger 1: Aluminium

Zwischenschicht 2: Eloxal

Barriereschicht 8: metallisches $Ni_{80}Cr_{20}$ (80:20 Gewichtsprozent) Haftvermittlerschicht 9 zwischen Barriereschicht 8 und Reflexionsschicht 6: $TiO_2$ Reflexionsschicht 6: Silber

Haftvermittlerschicht 10 zwischen Reflexionsschicht 6 und dielektrischer Schicht 5: $CrO_s$

untere dielektrische Schicht 5: $Al_2O_3$

obere dielektrische Schicht 4: $TiO_2$

Deckschicht 9: $SiO_2$ mit Kohlenstoffgehalt von 1%

Die über dem optischen Mehrschichtsystem 3 aufgebrachte Deckschicht 9 wurde mittels PE-CVD Verfahren aufgebracht.

Nach 1000 Stunden betrug der Abfall $\Delta R$ des Reflexionsgrades weniger als 1%. Der Test wurde bestanden.

Der Fachmann kann die Erfindung durch zusätzliche vorteilhafte Maßnahmen ergänzen, ohne dass der Rahmen der Erfindung verlassen wird. So kann - wie ebenfalls zeichnerisch dargestellt - auf der dem optischen Mehrschichtsystem 3 abgewandten Seite B, insbesondere auf dem Träger 1, der optional auch auf dieser Seite eine anodisch oxidierte Schicht 11 aufweisen kann, zusätzlich eine Dekorativschicht 12 aufgebracht sein. Diese Dekorativschicht 12 kann beispielsweise eine metallische oder aus Titannitrid oder anderen geeigneten Materialien, mit denen auch neben einem Glanz eine bestimmte Färbung verliehen werden kann, bestehende Spiegelschicht sein. Dies ist besonders dann von Vorteil, wenn aus dem erfindungsgemäßen Verbundmaterial V Reflektorkörper für Leuchten gefertigt werden sollen.

Ein weiterer bevorzugter Anwendungsfall ist die Platzierung von LED-Leuchtquellen, z. B. in Form eines Chips, auf der Oberfläche des erfindungsgemäßen Verbundmaterials V. Zu diesbezüglich weiteren möglichen Einzelheiten wird exemplarisch in vollem Umfang auf die DE 10 2012 108 719 A1 verwiesen.

Schließlich eignet sich das erfindungsgemäße Verbundmaterial V aufgrund seiner langzeitlich beständigen hohen Licht-Gesamtreflexion hervorragend zum Einsatz in Solaranlagen, die in Glashäusern installiert sind und Sonnenlicht zur Wärmeerzeugung konzentrieren, wie dies beispielsweise in der US 8 915 244 B2 beschrieben ist. Auch hier wird zu diesbezüglich weiteren möglichen Einzelheiten in vollem Umfang auf das genannte Dokument verwiesen.

In dem optischen Mehrschichtsystem 3 können über der Reflexionsschicht 6 nicht nur ein Paar von oberen dielektrischen und/oder oxidischen Schichten 4, 5, sondern auch mehrere derartige Paare angeordnet sein, wodurch die Reflektivität des erfindungsgemäßen Verbundmaterials V noch weiter verstärkt werden kann. Die optional vorhandene Haftvermittlerschicht 10 kann dabei mit Vorteil Bestandteil eines solchen Schichtpaares sein, wobei eine darin über ihr liegende Schicht einen entsprechend höheren Brechungsindex aufweisen sollte.

**Bezugszeichen**

1    Träger
2    Zwischenschicht, anodisch oxidierte Schicht auf A
3    optisches Mehrschichtsystem
4    obere dielektrische Schicht von 3
5    mittlere (untere dielektrische) Schicht von 3
6    Reflexionsschicht von 3

| | |
|---|---|
| 7 | Deckschicht |
| 8 | Barriereschicht |
| 9 | (erste) Haftvermittlerschicht zwischen 6 und 8 |
| 10 | (zweite) Haftvermittlerschicht zwischen 5 und 6 |
| 11 | anodisch oxidierte Schicht auf B |
| 12 | Dekorativschicht |
| A | Oberseite von 1 |
| B | Unterseite von 1 |
| D | (Gesamt-)Dicke von V |
| D1 | Dicke von 1 |
| D2 | Dicke von 2 |
| D4 | Dicke von 4 |
| D5 | Dicke von 5 |
| D6 | Dicke von 6 |
| D7 | Dicke von 7 |
| D8 | Dicke von 8 |
| D9 | Dicke von 9 |
| D10 | Dicke von 10 |
| V | Verbundmaterial |

**Patentansprüche**

1. Reflektierendes Verbundmaterial (V) mit einem aus Aluminium bestehenden Träger (1), mit einer auf einer Seite (A) auf dem Träger (1) befindlichen Zwischenschicht (2) aus anodisch oxidiertem Trägermaterial die eine Dicke ($D_2$) im Bereich von 10 nm bis 10,0 $\mu$m aufweist, und mit einem über der Zwischenschicht (2) aufgebrachten optisch wirksamen Mehrschichtsystem (3), welches aus mindestens drei Schichten besteht, wobei die oberen Schichten (4, 5) dielektrische und/oder oxidische Schichten sind, und die unterste Schicht (6) eine metallische, aus Silber bestehende, Schicht ist, welche eine Reflexionsschicht (6) mit hoher Gesamtreflexion im Bereich des sichtbaren Lichtes bildet,

   wobei über der Zwischenschicht (2) und unter der Reflexionsschicht (6) eine diffusionshemmende Barriereschicht (8) angeordnet ist, welche eine Wanderung von Silberteilchen aus der aus Silber bestehenden Schicht (6) durch die Zwischenschicht (2) in den aus Aluminium bestehenden Träger (1) verhindert, wobei die diffusionshemmende Barriereschicht (8) Palladium oder einen Stoff der chemischen Zusammensetzung $Cr_wNi_xN_yO_z$ enthält, wobei die Indizes w, x, y und z ein stöchiometrisches oder nichtstöchiometrisches Verhältnis bezeichnen und für die Indizes w, x, y, z gilt: $0 \leq w \leq 1$ und $0 \leq x \leq 1$, $0 \leq y \leq 1$, $0 \leq z \leq 5$, wobei mindestens einer der Indizes w oder x größer als Null ist, und wobei die Reflexionsschicht (6) über eine einseitig an die Reflexionsschicht (6) und anderseitig an die Barriereschicht (8) angrenzende Haftvermittlerschicht (9) an die Barriereschicht (8) angebunden ist, welche eine Adhäsion der aus Silber bestehenden Reflexionsschicht (6) an der Barriereschicht (8) erhöht, wobei ein nach DIN 5036, Teil 3 bestimmter Licht-Gesamtreflexionsgrad auf der Seite (A) des optischen Mehrschichtsystems (3) größer ist als 97 %, wobei bei einem Test entsprechend DIN ISO 9211-4:2006 oder ASTM D4585 nach mindestens 168 h Belastung bei erhöhter Temperatur ($\geq 50$ °C) keine optische Veränderung der Oberfläche oder eine Abnahme der Licht-Gesamtreflexion von weniger als 1 % - für LED Anwendungen nach DIN 5036-3 - oder eine Abnahme der solar gewichteten Gesamtreflexion von weniger als 1 % - für solare Anwendungen mit dem solaren Spektrum AM1.5 aus ASTM G173-03 - eintritt und bei einem Test mit einem Solarsimulator nach ASTM E-927-85 "Type Class A" bei einer gemessenen UV-A und UV-B Gesamtintensität auf der Probenoberfläche, welche eine Temperatur von mindestens 150 °C aufweist, die Abnahme der Licht-Gesamtreflexion Y (D65) oder der solar gewichteten Gesamtreflexion $R_{solar}$ geringer ist als 1 %, wobei die zum Erreichen dieser Reflexionsänderung zu bestehende Belastungsdauer im Falle einer UV-Gesamtintensität von 150 mW/cm$^2$ mindestens 500 h und im Falle einer UV-Gesamtintensität von 70 mW/cm$^2$ mindestens 1000 h beträgt.

2. Verbundmaterial (V) nach Anspruch 1,
   **dadurch gekennzeichnet, dass** die Barriereschicht (8) eine metallische oder nitridische Schicht ist.

3. Verbundmaterial (V) nach Anspruch 1 oder 2,
   **dadurch gekennzeichnet, dass** die Barriereschicht (8) metallisches Chrom oder Nickel oder eine Chrom-Nickel-Legierung enthält oder gänzlich aus diesen Stoffen besteht.

4. Verbundmaterial (V) nach einem der Ansprüche 1 bis 3,
**dadurch gekennzeichnet, dass** die Barriereschicht (8) eine Dicke (D8) im Bereich von 5 nm bis 500 nm, vorzugsweise 10 nm bis 200 nm, besonders bevorzugt 15 bis 70 nm, aufweist.

5. Verbundmaterial (V) nach einem der Ansprüche 1 bis 4,
**dadurch gekennzeichnet, dass** die obere dielektrische und/oder oxidische Schicht (4) des optischen Mehrschichtsystems (3) eine höher brechende Schicht ist als die untere dielektrische und/oder oxidische Schicht (5) des optischen Mehrschichtsystems (3), wobei die obere Schicht (4) vorzugsweise aus $Ta_2O_5$, $Nb_2O_5$, $MoO_3$, $TiO_2$ und/oder $ZrO_2$, und die untere Schicht (5) vorzugsweise aus $Al_2O_3$ und/oder $SiO_2$ besteht.

6. Verbundmaterial (V) nach einem der Ansprüche 1 bis 5,
**dadurch gekennzeichnet, dass** zwischen der untersten dielektrischen und/oder oxidischen Schicht (5) des optischen Mehrschichtsystems (3) und der Reflexionsschicht (6) eine weitere Haftvermittlerschicht (10) angeordnet ist.

7. Verbundmaterial (V) nach einem der Ansprüche 1 bis 6,
**dadurch gekennzeichnet, dass** die Haftvermittlerschicht(en) (9, 10) (eine) oxidische Schicht(en) ist/sind.

8. Verbundmaterial (V) nach einem der Ansprüche 1 bis 7,
**dadurch gekennzeichnet, dass** die Haftvermittlerschicht(en) (9, 10) aus $Al_2O_3$, $TiO_2$ oder $CrO_s$ gebildet ist/sind, wobei s ein stöchiometrisches oder nichtstöchiometrisches Verhältnis bezeichnet und im Bereich $0 < s < 1,5$ liegt.

9. Verbundmaterial (V) nach einem der Ansprüche 1 bis 8,
**dadurch gekennzeichnet, dass** die Haftvermittlerschicht(en) (9, 10) jeweils eine Dicke (D9, D10) im Bereich von 0,1 nm bis 50 nm aufweisen, wobei für die Haftvermittlerschicht (9) zwischen der Barriereschicht (8) und der Reflexionsschicht (6) eine Dicke (D9) im Bereich von 5 nm bis 25 nm bevorzugt, und eine Dicke (D9) im Bereich 10 nm bis 20 nm besonders bevorzugt ist, und für die Haftvermittlerschicht (10) zwischen der Reflexionsschicht (6) und der untersten dielektrischen und/oder oxidischen Schicht (5) des optischen Mehrschichtsystems (3) eine Dicke (D10) im Bereich von 0,1 nm bis 10 nm bevorzugt, und eine Dicke (D10) im Bereich 0,5 nm bis 5 nm besonders bevorzugt ist.

10. Verbundmaterial (V) nach einem der Ansprüche 1 bis 9,
**dadurch gekennzeichnet, dass** die Dicke (D6) der Reflexionsschicht (6) im Bereich von 30 nm bis 200 nm, bevorzugt im Bereich von 40 nm bis 150 nm, besonders bevorzugt im Bereich 50 nm bis 100 nm, liegt.

11. Verbundmaterial (V) nach einem der Ansprüche 1 bis 10,
**dadurch gekennzeichnet, dass** auf das optische Mehrschichtsystem (3) eine siliciumoxidische und/oder siliciumnitridische Deckschicht (7) aufgebracht ist.

12. Verbundmaterial nach einem der Ansprüche 1 bis 11,
**dadurch gekennzeichnet, dass** auf das optische Mehrschichtsystem (3) als Deckschicht (7), insbesondere als CVD-Schicht, bevorzugt als PE-CVD Schicht, eine Mischschicht der chemischen Zusammensetzung $Si_aC_bO_cN_dH_e$ aufgebracht ist, wobei die Indizes a, b, c, d und e ein stöchiometrisches oder nichtstöchiometrisches Verhältnis bezeichnen und derart eingestellt sind, dass die Deckschicht (7) bei einer gewählten Schichtdicke (D7) nur eine geringe Lichtabsorption, insbesondere eine Lichtabsorption von weniger als 10 Prozent, bevorzugt von weniger als 5 Prozent, besonders bevorzugt von weniger als 1 Prozent, aufweist, und wobei der Kohlenstoffgehalt - bezogen auf die Gesamtmasse der Deckschicht (7) - im Bereich von 0 Atomprozent, insbesondere von 0,2 Atomprozent, bis 15,0 Atomprozent, bevorzugt im Bereich von 0,8 Atomprozent bis 4,0 Atomprozent, liegt, wobei für einen Index a = 1 die anderen Indizes in folgenden Bereichen liegen: $0 \leq b \leq 2$, $0 \leq c \leq 2$, $0 \leq d \leq 4/3$, $0 \leq e \leq 1$, unter der Maßgabe, dass mindestens einer der Indizes b, c, d von Null verschieden ist.

13. Verbundmaterial nach einem der Ansprüche 1 bis 10,
**dadurch gekennzeichnet, dass** auf das optische Mehrschichtsystem (3) als Deckschicht (7) eine siliciumorganische Lackschicht auf Basis einer Sol-Gel-Schicht, insbesondere mit einer bevorzugten Schichtdicke im Bereich von 0,5 μm bis 5μm, aufgebracht ist.

14. Verbundmaterial nach einem der Ansprüche 1 bis 13,
**dadurch gekennzeichnet, dass** die Zwischenschicht (2) eine Dicke ($D_2$) im Bereich von 500 nm bis 2,0 μm, bevorzugt im Bereich von 700 nm bis 1,5 μm, aufweist.

**15.** Verbundmaterial (V) nach einem der Ansprüche 1 bis 14,
**dadurch gekennzeichnet, dass** eine oder mehrere der über der Zwischenschicht (2) angeordneten Schichten (4, 5, 6, 7, 8, 9, 10) Sputterschichten, insbesondere durch Reaktivsputtern erzeugte Schichten, CVD- oder PECVD-Schichten oder durch Verdampfen, insbesondere durch Elektronenbombardement oder aus thermischen Quellen, erzeugte Schichten sind.


**Claims**

**1.** Reflective composite material (V) having a substrate (1) consisting of aluminium, having an intermediate layer (2) of anodically oxidized substrate material which is located on one side (A) of the substrate (1) and comprises a thickness ($D_2$) in the range of 10 nm to 10.0 $\mu$m, and having an optically active multilayer system (3) applied over the intermediate layer (2), which consists of at least three layers, the upper layers (4, 5) being dielectric and/or oxidic layers, and the lowest layer (6) being a metallic layer consisting of silver, which forms a reflective layer (6) with a high overall reflectance in the region of visible light,
wherein a diffusion-inhibiting barrier layer (8) is arranged above the intermediate layer (2) and below the reflective layer (6), which prevents migration of silver particles from the layer (6) consisting of silver through the intermediate layer (2) into the carrier (1) consisting of aluminium, wherein the diffusion-inhibiting barrier layer (8) contains palladium or a substance of the chemical composition $Cr_wNi_xN_yO_z$, wherein the indices w, x, y and z denote a stoichiometric or non-stoichiometric ratio and the following applies to the indices w, x, y, z: $0 \leq w \leq 1$ and $0 \leq x \leq 1$, $0 \leq y \leq 1$, $0 \leq z \leq 5$, wherein at least one of the indices w or x is larger than zero, and wherein the reflective layer (6) is bonded to the barrier layer (8) via an adhesion promoter layer (9) which is adjacent to the reflective layer (6) on one side and to the barrier layer (8) on the other side, which increases an adhesion of the reflective layer (6) consisting of silver to the barrier layer (8), wherein a total light reflectance on the side (A) of the optical multilayer system (3) determined according to DIN 5036, part 3 is larger than 97 %, wherein in a test according to DIN ISO 9211-4:2006 or ASTM D4585 after at least 168 h exposure at elevated temperature ($\geq 50$ °C) no optical change of the surface or a decrease of the total light reflectance of less than 1 % - for LED applications according to DIN 5036-3 - or a decrease of the solar weighted total reflectance of less than 1 % - for solar applications with the solar spectrum AM1.5 from ASTM G173-03 - and in a test with a solar simulator according to ASTM E-927-85 "Type Class A" at a measured UV-A and UV-B total intensity on the sample surface comprising a temperature of at least 150 °C, the decrease in the total light reflectance Y (D65) or the solar-weighted total reflectance $R_{solar}$ is less than 1 %, whereby the exposure time required to achieve this change in reflectance is at least 500 h in the case of a total UV intensity of 150 mW/cm$^2$ and at least 1000 h in the case of a total UV intensity of 70 mW/cm$^2$.

**2.** Composite material (V) according to claim 1,
**characterised in that** the barrier layer (8) is a metallic or nitride layer.

**3.** Composite material (V) according to claim 1 or 2,
**characterised in that** the barrier layer (8) contains metallic chromium or nickel or a chromium-nickel alloy or consists entirely of these substances.

**4.** Composite material (V) according to one of claims 1 to 3,
**characterised in that** the barrier layer (8) comprises a thickness (D8) in the range of 5 nm to 500 nm, preferably 10 nm to 200 nm, particularly preferably 15 to 70 nm.

**5.** Composite material (V) according to one of claims 1 to 4,
**characterised in that** the upper dielectric and/or oxidic layer (4) of the optical multilayer system (3) is a higher refracting layer than the lower dielectric and/or oxidic layer (5) of the optical multilayer system (3), wherein the upper layer (4) preferably consists of $Ta_2O_5$, $Nb_2O_5$, $MoO_3$, $TiO_2$ and/or $ZrO_2$, and the lower layer (5) preferably consists of $Al_2O_3$ and/or $SiO_2$.

**6.** Composite material (V) according to one of claims 1 to 5,
**characterised in that** a further adhesion promoter layer (10) is arranged between the lowest dielectric and/or oxidic layer (5) of the optical multilayer system (3) and the reflective layer (6).

**7.** Composite material (V) according to one of claims 1 to 6,
**characterised in that** the adhesion promoter layer(s) (9, 10) is/are (an) oxidic layer(s).

8.  Composite material (V) according to one of claims 1 to 7,
    **characterised in that** the adhesion promoter layer(s) (9, 10) is/are formed from $Al_2O_3$, $TiO_2$ or $CrO_s$, where s denotes a stoichiometric or non-stoichiometric ratio and lies in the range 0 < s < 1.5.

9.  Composite material (V) according to one of claims 1 to 8,
    **characterised in that** the adhesion promoter layer(s) (9, 10) each comprise a thickness (D9, D10) in the range of 0.1 nm to 50 nm, a thickness (D9) in the range of 5 nm to 25 nm being preferred for the adhesion promoter layer (9) between the barrier layer (8) and the reflective layer (6), and a thickness (D9) in the range of 10 nm to 20 nm being particularly preferred, and for the adhesion promoter layer (10) between the reflective layer (6) and the lowest dielectric and/or oxidic layer (5) of the optical multilayer system (3), a thickness (D10) in the range of 0.1 nm to 10 nm is preferred, and a thickness (D10) in the range of 0.5 nm to 5 nm is particularly preferred.

10. Composite material (V) according to one of claims 1 to 9,
    **characterised in that** the thickness (D6) of the reflective layer (6) is in the range of 30 nm to 200 nm, preferably in the range of 40 nm to 150 nm, particularly preferably in the range of 50 nm to 100 nm.

11. Composite material (V) according to one of claims 1 to 10,
    **characterised in that** a silicon oxide and/or silicon nitride cover layer (7) is applied to the optical multilayer stem (3).

12. Composite material according to one of claims 1 to 11,
    **characterised in that** a mixed layer of the chemical composition $Si_aC_bO_cN_dH_e$ is applied to the optical multilayer system (3) as a cover layer (7), in particular as a CVD layer, preferably as a PE-CVD layer, wherein the indices a, b, c, d and e denote a stoichiometric or non-stoichiometric ratio and are set such that the cover layer (7) has only a low light absorption at a selected layer thickness (D7), in particular a light absorption of less than 10 percent, preferably of less than 5 percent, particularly preferably of less than 1 percent, and wherein the carbon content - relative to the total mass of the cover layer (7) - is in the range of 0 atomic percent, in particular of 0.2 atomic percent, to 15.0 atomic percent, preferably in the range of 0.8 atomic percent to 4.0 atomic percent, wherein for an index a = 1 the other indices are in the following ranges: $0 \leq b \leq 2$, $0 \leq c \leq 2$, $0 \leq d \leq 4/3$, $0 \leq e \leq 1$, with the proviso that at least one of the indices b, c, d is different from zero.

13. Composite material according to one of claims 1 to 10,
    **characterised in that** an organosilicon lacquer layer based on a sol-gel layer, in particular with a preferred layer thickness in the range of 0.5 $\mu$m to 5 $\mu$m, is applied to the optical multilayer system (3) as a cover layer (7).

14. Composite material according to any one of claims 1 to 13,
    **characterised in that** the intermediate layer (2) comprises a thickness ($D_2$) in the range of 500 nm to 2.0 $\mu$m, preferably in the range of 700 nm to 1.5 $\mu$m.

15. Composite material (V) according to one of claims 1 to 14,
    **characterised in that** one or more of the layers (4, 5, 6, 7, 8, 9, 10) arranged above the intermediate layer (2) are sputter layers, in particular layers produced by reactive sputtering, CVD or PECVD layers or layers produced by evaporation, in particular by electron bombardment or from thermal sources.

## Revendications

1.  Matériau composite réfléchissant (V) comportant un support (1) constitué d'aluminium, comportant une couche intermédiaire (2) se trouvant d'un côté (A) sur le support (1), à base de matériau de support oxydé par voie anodique, qui présente une épaisseur ($D_2$) dans la plage de 10 nm à 10,0 $\mu$m, et comportant un système multicouche (3) optiquement actif appliqué sur la couche intermédiaire (2), qui consiste en au moins trois couches, les couches supérieures (4, 5) étant des couches diélectriques et/ou de type oxyde, et la couche la plus basse (6) étant une couche métallique constituée d'argent, qui forme une couche de réflexion (6) à haute réflexion totale dans la région de la lumière visible,
    dans lequel sur la couche intermédiaire (2) et sous la couche de réflexion (6) est disposée une couche barrière (8) anti-diffusion, qui empêche une migration de particules d'argent depuis la couche (6) constituée d'argent, à travers la couche intermédiaire (2), dans le support (1) constitué d'aluminium, la couche barrière (8) anti-diffusion contenant du palladium ou une substance de composition chimique $Cr_wNi_xN_yO_z$, dans laquelle les indices w, x, y et z désignent un rapport stoechiométrique ou non stoechiométrique et pour les indices w, x, y, z il s'applique que $0 \leq w \leq 1$ et 0

$\leq$ x $\leq$ 1, 0 $\leq$ y $\leq$ 1, 0 $\leq$ z $\leq$ 5, au moins un des indices w et x étant supérieur à zéro, et dans lequel la couche de réflexion (6) est raccordée à la couche barrière (8) par l'intermédiaire d'une couche favorisant l'adhérence (9), adjacente d'un côté à la couche de réflexion (6) et de l'autre côté à la couche barrière (8), qui augmente une adhérence de la couche de réflexion (6) constituée d'argent à la couche barrière (8), dans lequel un degré de réflexion totale de la lumière, déterminé selon DIN 5036, partie 3, sur la face (A) du système multicouche optique (3) est supérieur à 97 %, dans lequel dans un essai selon DIN ISO 9211-4:2006 ou ASTM D4585 après sollication pendant au moins 168 h à température élevée ($\geq$ 50 °C) il n'apparaît aucune modification optique de la surface ou il apparaît une diminution de la réflexion totale de la lumière de moins de 1 % - pour des applications de LED selon DIN 5036-3 - ou une diminution de la réflexion totale pondérée par l'énergie solaire de moins de 1 % - pour des applications solaires avec le spectre solaire AM1.5 d'après ASTM G173-03 - et dans un essai avec un simulateur solaire selon ASTM E-927-85 « Type Classe A » à une intensité totale d'UV-A et UV-B mesurée sur la surface d'échantillon qui présente une température d'au moins 150 °C, la diminution de la réflexion totale Y (D65) de la lumière ou de la réflexion totale pondérée par l'énergie solaire $R_{solar}$ est inférieure à 1 %, la durée de sollicitation nécessaire pour atteindre cette modification de la réflexion étant d'au moins 500 h dans le cas d'une intensité totale d'UV de 150 mW/cm$^2$ et d'au moins 1 000 h dans le cas d'une intensité totale d'UV de 70 mW/cm$^2$.

2. Matériau composite (V) selon la revendication 1,
**caractérisé en ce que** la couche barrière (8) est une couche métallique ou de type nitrure.

3. Matériau composite (V) selon la revendication 1 ou 2,
**caractérisé en ce que** la couche barrière (8) contient du chrome ou nickel métallique ou un alliage nickel-chrome ou est entièrement constituée de ces matières.

4. Matériau composite (V) selon l'une quelconque des revendications 1 à 3,
**caractérisé en ce que** la couche barrière (8) présente une épaisseur (D8) dans la plage de 5 nm à 500 nm, de préférence 10 nm à 200 nm, de façon particulièrement préférée 15 à 70 nm.

5. Matériau composite (V) selon l'une quelconque des revendications 1 à 4,
**caractérisé en ce que** la couche supérieure (4) diélectrique et/ou de type oxyde du système multicouche optique (3) est une couche à indice de réfraction plus élevé que la couche inférieure (5) diélectrique et/ou de type oxyde du système multicouche optique (3), la couche supérieure (4) étant de préférence constituée de $Ta_2O_5$, $Nb_2O_5$, $MoO_3$, $TiO_2$ et/ou $ZrO_2$, et la couche inférieure (5) étant de préférence constituée de $Al_2O_3$ et/ou $SiO_2$.

6. Matériau composite (V) selon l'une quelconque des revendications 1 à 5, **caractérisé en ce qu'**une couche supplémentaire (10) favorisant l'adhérence est disposée entre la couche (5) diélectrique et/ou de type oxyde la plus basse du système multicouche optique (3) et la couche de réflexion (6).

7. Matériau composite (V) selon l'une quelconque des revendications 1 à 6,
**caractérisé en ce que** la/les couche(s) favorisant l'adhérence (9, 10) est/sont une/des couche(s) de type oxyde.

8. Matériau composite (V) selon l'une quelconque des revendications 1 à 7,
**caractérisé en ce que** la/les couche(s) favorisant l'adhérence (9, 10) est/sont constituée(s) de $Al_2O_3$, $TiO_2$ ou $CrO_s$, s désignant un rapport stoechiométrique ou non stoechiométrique et se situant dans la plage 0 < s < 1,5.

9. Matériau composite (V) selon l'une quelconque des revendications 1 à 8,
**caractérisé en ce que** la/les les couche(s) favorisant l'adhérence (9, 10) présentent chacune une épaisseur (D9, D10) dans la plage de 0,1 nm à 50 nm, pour la couche favorisant l'adhérence (9) entre la couche barrière (8) et la couche de réflexion (6), une épaisseur (D9) dans la plage de 5 nm à 25 nm étant préférée, et une épaisseur (D9) dans la plage de 10 nm à 20 nm étant particulièrement préférée, et pour la couche favorisant l'adhérence (10) entre la couche de réflexion (6) et la couche (5) diélectrique et/ou de type oxyde la plus basse du système multicouche optique (3), une épaisseur (D10) dans la plage de 0,1 nm à 10 nm étant préférée, et une épaisseur (D10) dans la plage de 0,5 nm à 5 nm étant particulièrement préférée.

10. Matériau composite (V) selon l'une quelconque des revendications 1 à 9,
**caractérisé en ce que** l'épaisseur (D6) de la couche de réflexion (6) se situe dans la plage de 30 nm à 200 nm, de préférence dans la plage de 40 nm à 150 nm, de façon particulièrement préférée dans la plage de 50 nm à 100 nm.

11. Matériau composite (V) selon l'une quelconque des revendications 1 à 10,

**caractérisé en ce qu'**une couche de recouvrement (7) de type oxyde de silicium et/ou de type nitrure de silicium est appliquée sur le système multicouche optique (3).

12. Matériau composite selon l'une quelconque des revendications 1 à 11,
**caractérisé en ce qu'**une couche mixte de composition chimique $Si_aC_bO_cN_dH_e$ est appliquée sur le système multicouche optique (3) en tant que couche de recouvrement (7), en particulier en tant que couche de CVD, de préférence en tant que couche de PE-CVD, les indices a, b, c, d et e désignant un rapport stoechiométrique ou non stoechiométrique et étant ajustés de telle manière que la couche de recouvrement (7), en une épaisseur de couche (D7) choisie, ne présente qu'une faible absorption de la lumière, en particulier une absorption de la lumière de moins de 10 pour cent, de préférence de moins de 5 pour cent, de façon particulièrement préférée de moins de 1 pour cent, et la teneur en carbone - par rapport à la masse totale de la couche de recouvrement (7) - se situant dans la plage de 0 pour cent en atomes, en particulier de 0,2 pour cent en atomes, à 15,0 pour cent en atomes, de préférence dans la plage de 0,8 pour cent en atomes à 4,0 pour cent en atomes, pour un indice a = 1 les autres indices se situant dans les plages suivantes : $0 \leq b \leq 2$, $0 \leq c \leq 2$, $0 \leq d \leq 4/3$, $0 \leq e \leq 1$, étant entendu qu'au moins un des indices b, c, d est différent de zéro.

13. Matériau composite selon l'une quelconque des revendications 1 à 10,
**caractérisé en ce qu'**une couche de vernis organosilicié à base d'une couche sol-gel est appliquée en tant que couche de recouvrement (7) sur le système multicouche optique (3), en particulier en une épaisseur préférée de couche dans la plage de 0,5 $\mu$m à 5 $\mu$m.

14. Matériau composite selon l'une quelconque des revendications 1 à 13,
**caractérisé en ce que** la couche intermédiaire (2) présente une épaisseur (D2) dans la plage de 500 nm à 2,0 $\mu$m, de préférence dans la plage de 700 nm à 1,5 $\mu$m.

15. Matériau composite (V) selon l'une quelconque des revendications 1 à 14,
**caractérisé en ce que** qu'une ou plusieurs des couches (4, 5, 6, 7, 8, 9, 10) disposées sur la couche intermédiaire (2) sont des couches déposées par pulvérisation cathodique, en particulier des couches produites par pulvérisation cathodique réactive, des couches de CVD ou PECVD ou des couches produites par évaporation, en particulier par bombardement d'électrons ou à partir de sources thermiques.

**Fig. 1**

EP 3 341 770 B1

## Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1867934 A1
- DE 102012108719 A1

- US 8915244 B2